Europäisches Patentamt

European Patent Office

Office européen des brevets

(11) Publication number: **0 210 605 B1**

# EUROPEAN PATENT SPECIFICATION

(45) Date of publication of patent specification: **27.02.91**

(51) Int. Cl.⁵: **H01J 37/32**

(21) Application number: **86110241.6**

(22) Date of filing: **25.07.86**

(54) **Plasma processing method and apparatus.**

(30) Priority: **25.07.85 US 759616**

(43) Date of publication of application:
**04.02.87 Bulletin 87/06**

(45) Publication of the grant of the patent:
**27.02.91 Bulletin 91/09**

(84) Designated Contracting States:
**DE FR GB**

(56) References cited:
**WO-A-82/02979**

**PATENT ABSTRACTS OF JAPAN, vol. 8, no. 103 (E-244)[1540], 15th May 1984; & JP-A-59 19 326**

(73) Proprietor: **TEXAS INSTRUMENTS INCORPO-RATED**
**13500 North Central Expressway**
**Dallas Texas 75265(US)**

(72) Inventor: **Wooldridge, Timothy A.**
**402 Crestover Circle**
**Richardson, TX 75080(US)**
Inventor: **Bonifield, Thomas D.**
**10040 Lakemere**
**Dallas, TX 75238(US)**
Inventor: **Abernathy, Joe V.**
**3655 Touchstone**
**Wylie, TX 75098(US)**
Inventor: **Davis, Cecil J.**
**Rt. 4, Box 113C**
**Greenville, TX 75401(US)**
Inventor: **Jucha, Rhett B.**
**Rt. 1, Box 113-1A**
**Celeste, TX 75423(US)**

(74) Representative: **Leiser, Gottfried, Dipl.-Ing. et al**
**Patentanwälte Prinz, Leiser, Bunke & Partner**
**Manzingerweg 7**
**D-8000 München 60(DE)**

## Description

The present invention relates to devices and methods for fabrication of integrated circuits.

In modern integrated circuit fabrication, plasma processing is universally used for a large number of steps. Plasma etching generates a glow discharge close to an integrated circuit wafer in a source gas mixture, so that free radicals and ions are generated to etch the species on the wafer surface, assisted by ion bombardment in degrees which vary depending on the total gas pressure, electrode configuration, and various other factors. Depending on the material being etched, the pressure may be anywhere from a few thousandth mbar to a few mbar, or even wider than this range. Processes using pressures in the lower part of this range are commonly referred to as reactive ion etching (RIE) processes, but the present invention is also applicable to such etch processes.

The present invention is primarily applicable to plasma etching although it is also applicable to other processing techniques which use plasmas in proximity to an integrated circuit, such as generation of a hydrogen plasma to assist in diffusion of atomic hydrogen to passivate polysilicon active devices.

In plasma etching, the wafer will generally be supported on a susceptor which includes cooling fluid connections, and a facing electrode will be separately connected to another terminal of the power supply. This configuration is referred to as a "parallel plate" reactor. When an RF voltage is applied between the susceptor and the electrode, a plasma will be initiated in the low-pressure gas between them and etching begins. In the prior art, electrodes for plasma etching have been made from a wide variety of materials, including aluminum, stainless steel, graphite, and other metals.

The present invention is particularly advantageous in single-slice parallel plate etching reactors. Single-slice reactors have the advantage over multi-slice parallel plate reactors that wafer-to-wafer uniformity is enhanced. In such reactors, the volume of the process chamber is kept to an absolute minimum to facilitate rapid throughput without excessive time requirements for pumpdown and purging. Typically process gases will be supplied to the process chamber through holes in the electrode, and exhausted through exhaust vents around the periphery of the wafer. However, in a typical single-slice reactor, the electrode and the susceptor may be separated by only a centimeter or so, and the electrode will be exposed to ion bombardment to approximately the same degree that the wafer will. This causes the problem in the prior art that electrode material may be sputtered off the electrode and deposited onto the wafer, which will cause a variety of problems depending on the device being built.

This is a particular problem in oxide etching. In etching silicon oxides, high ion bombardment conditions are typically required, and high power density is preferably used to obtain acceptable etching rates. However, the fluorine-based plasmas normally used for oxide etching cannot volatilize the electrode material sputtered off of many of the electrodes which would normally be preferably. For example, fluorine will not volatilize transition metals or aluminum. Graphite has been the preferred electrode for oxide etching previously, because fluorocarbons are volatile. However, since graphite electrodes are polycrystalline, this same reactivity causes another problem: etching will proceed selectively along the grain boundaries of the graphite, so that carbon particles, of sizes in the neighborhood of a micrometer, may be freed from the carbon electrodes to be dropped onto the wafer and cause contamination.

Moreover, uniformity of ion bombardment is critical in oxide etching, and the necessary degree of uniformity cannot be attained in large volumes. Thus oxide etching is normally performed in single-slice reactors, or in other reactors which have conditions similar to those found in single-slice reactors.

To avoid this problem with graphite electrodes, one possibility would be to apply coatings to the electrodes. For example, one manufacturer currently uses electrodes of silicon sprayed on aluminum; another uses an aluminum electrode under conditions where polymer is continually being deposited on it (which leads to especially severe particulate problems); another uses a graphite electrode with holes (for gas flow) in it. RIE reactors for oxide etching generally have to protect all internal metal parts, not merely the electrode; usually this is done with a polymer coating of some sort.

However, protective coatings are always inherently susceptible to being sputtered away, and eventually the coating will be gone and sputtering of the electrodes will resume. Again, this is particularly a problem with high-power processes. A further disadvantage of this possibility is that preparation of properly coated electrodes is difficult and expensive.

The present invention eliminates the problem of particulates sputtered off of the electrode, and also eliminates any need for coating the electrode. The present invention also advantageously provides an electrode having an excellent lifetime and durability.

The present invention uses a silicon electrode in plasma etching. In many etch processes, this electrode has the advantage that the silicon electrode has volatile etch byproducts, so that no particulates are created from the electrode by the etch process. This electrode also has the advantage that it is wholly monocrystalline, so that no effect of preferential etching on grain boundaries can produce particulates.

A problem with aluminum or stainless steel electrodes is a drop in the etch rate as etching progresses. This problem is not well understood, but may be caused by thermal warpage of the electrode, and loss of contact to the powered back plate behind the electrode, as etching progresses and the electrode heats up. This problem too is avoided by the present invention.

The present invention is immediately attractive as a way to reduce particulate levels, but it also produces more uniform etching: both batch-to-batch uniformity and uniformity across a wafer are improved. The reasons for these two improvements are not well understood, but they do provide two additional very important advantages of the present invention.

The present invention thus has the following crucial advantages over the prior art: longevity; higher etch rate; reduced number of particulates; greater slice-to-slice uniformity; and greater uniformity across a slice; and other advantages as well.

According to the present invention there is provided: A process for plasma treatment of integrated circuit wafers, comprising the steps of: inserting a wafer onto a susceptor in a vacuum chamber; evacuating said vacuum chamber and flowing predetermined process gases therein; applying rf power between said susceptor and a monocrystalline silicon electrode.

According to the present invention there is also provided: A plasma reactor comprising: a susceptor with means for holding a semiconductor wafer thereon; an electrode comprising monocrystalline silicon; and means for applying rf power between said susceptor and said electrode.

The present invention will be described with reference to the drawings, wherein:

Figure 1 shows a sample embodiment of the present invention in a single-slice plasma reactor;

Figure 2 shows a sample embodiment of a monocrystalline silicon electrode according to the present invention;

Figure 3 shows a sample method for fabricating the silicon electrode used in the invention.

The present invention will be described with reference to particular preferred embodiments thereof, but it should be recognized that the present invention can also be used in a wide range of other embodiments. The embodiments provided are illustrative and intend to set forth the presently preferred best mode of the invention, together with a few preferred alternatives.

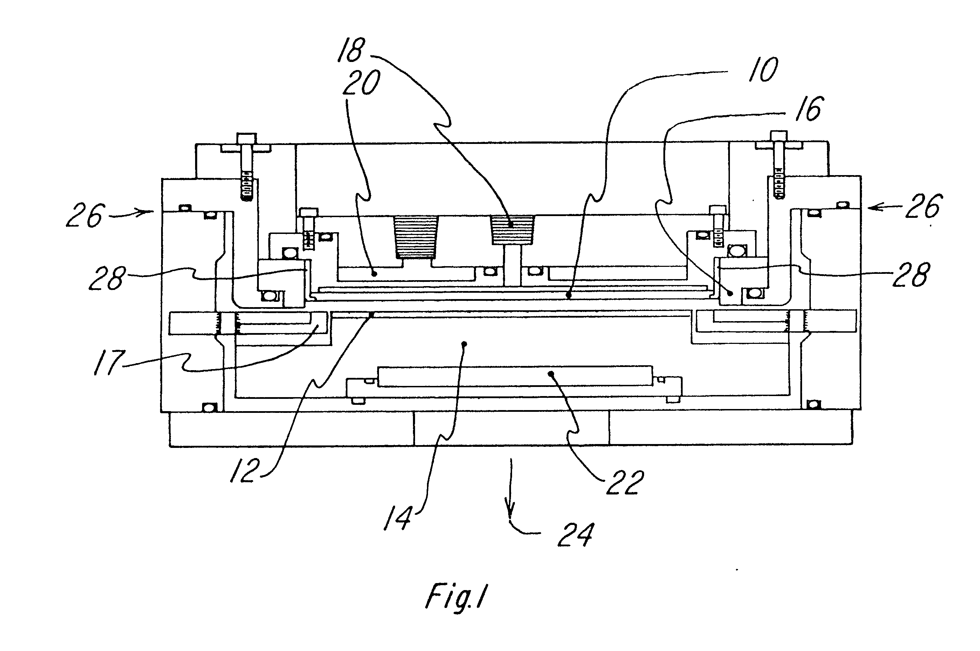

Figure 1 shows a first sample embodiment of the present invention. This shows a single-slice plasma reactor in the closed position, i.e., in the position where rf power would be applied. A wafer 12, for example 10,16 cm four inches in diameter, is supported on a susceptor 14. The susceptor 14 includes a manifold 22 through which coolant can be flowed to regulate the temperature of the wafer. The wafer is opposed at a low separation, e.g. 4,75 mm(3/16th of an inch), by an electrode 10. The electrode 10 is made of single-crystal silicon having multiple holes therein, and is preferably supported by a retaining ring 28. A manifold 20 is optionally used for electrode coolant. A process gas inlet 18 supplies process gases to the backside of the electrode 10, so that these gases flow through the holes in electrode 10 into the space defined between electrode 10 and wafer 12. These gases flow out around the periphery of wafer 12, to be exhausted through exhaust port 24. Note that a dielectric 17 preferably laterally surrounds the edge of wafer 12, so that the plasma is generated primarily above the face of wafer 12. This provides a uniform plasma, and avoids any enhanced ion bombardment rate near the edges of the wafer 12. A collimator 16 helps provide uniform alignment of the wafer to the electrode. An O-ringed mating surface 26 permits opening and closing the process chamber so that wafers can be removed easily.

In a sample application of the present invention, this apparatus is used for plasma etching of oxides. For example, in the sample application, the space in between the surface of the electrode 10 and the surface of wafer 12 would be approximately 4.5 mm, and, for a wafer 12 having a 10,16 cm (4 inch)diameter and electrode 10 having a 10,16 cm(4 inch) diameter, an rf power of 230 watts would be applied between them. For oxide etching, a fluorine-bearing gas mixture would be used, such as $CHF_3$ mixed with a little $O_2$; for example, 90 sccm of $CHF_3$ could be flowed together with 4 sccm of $O_2$, together with 150 sccm of helium for cooling, to provide a total process gas pressure of 0,93 mb (700 milliTorr). Under these conditions, a CVD undoped silicon oxide will etch at a rate in the neighborhood of 60 µm (6000 angstroms) per minute.

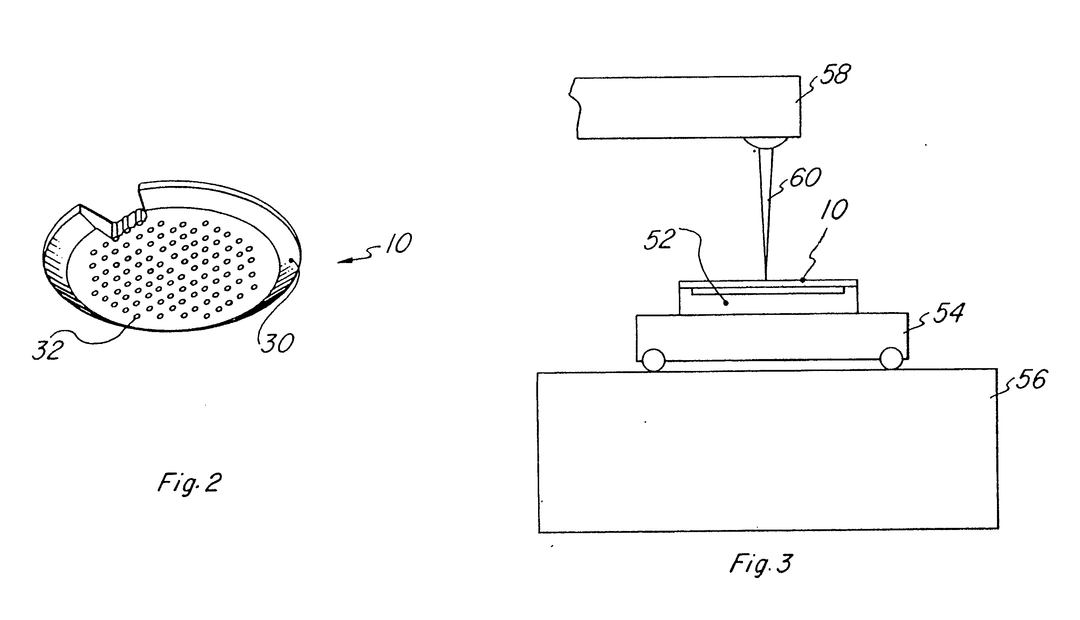

Figure 2 shows the electrode 10, in the presently preferred embodiment, in greater detail. Note that the electrode is substantially thicker than a standard silicon wafer. Preferably the electrode is at least 1,8 mm (.070 inches) thick. This not only provides longer lifetime, but providing more margin against erosion of the electrode by the process gases, but also provides mechanical strength to withstand the pressure differential which occurs during a typical purge cycle. (During a typical purge cycle the exhaust port 24 would be connected to a roughing vacuum pump, while the process gas inlet 18 would be connected to dry nitrogen at a pressure of 2,1 bar (30 psi).

The holes 32 in the electrodes 10 are preferably relatively small, i.e., less than 0,5 mm (0.020 inches) in diameter, in order to provide a uniform distribution of process gases over the wafer.

Note that the electrode 10 also preferably has a chamfered edge 30 to facilitate clamping by the clamping ring 28 shown in Figure 1.

The fabrication of these multiple holes in monocrystalline silicon is not possible by conventional machining means such as drilling or punching. To fabricate this electrode, the presently preferred embodiment uses laser drilling, as shown in Figure 3. Electrode 10 is supported on electrode holder 52 which is carried on an XY stage 54 supported on a solid table 56. A laser head 58 applies a high intensity laser spot 60, and attacks the silicon electrode 10 by ablation caused by repeated high power pulses. Preferably the hole is drilled by cutting multiple concentric circles with the laser beam. Preferably a first circle is drilled through the electrode at 20% of the desired diameter for the hole 32, and another circle is then drilled at 30% of the full diameter, until by succession of such steps a full diameter hole has been drilled. The stage is then moved to position the next hole position for drilling. The typical time requirement for drilling a 0,5 mm (0.020) inches diameter hole and moving to the next hole is 45 seconds, using a YAG laser CO2), at approximately 5 watts and 16 amps at a pulse rate of 3khz. After all holes are drilled, cleanup of the electrode is performed with a mixture of hydrochloric, nitric and acetic acids, to remove the slag deposited by drilling and to smooth the rough surfaces of the holes in electrode 10.

Alternatively, other methods could be used to drill the holes in the electrode 10. For example, orientation dependent etching could be used instead. Preferably a thick slice of 110 oriented silicon is used. After the thick 110 slice is ground and polished, an oxide film is grown to serve as a hard mask, and is patterned. The silicon is then wet etched according to the hard mask pattern with an orientation dependent wet etch step, using an etch such as acqueous potassium hydroxide, edetate disodium phosphate, or HF plus HNO3 plus acetic acid.

As noted above, the present invention has numerous advantages. In a sample application of the present invention, the number of particles between 0.2 and 2 $\mu$m found on a wafer after a plasma processing step was measured using both a graphite electrode and a silicon electrode, in a 10,16(four inch) plasma reactor according to the present invention. The background particle level, (i.e. the level measured after loading in the wafer, pumping down, purging, and then unloading the wafer, without applying any rf power) was found to be 35 particles in the reactor according to the present invention and 70 particles in the graphite electrode reactor. When rf power is applied, that is, when a wafer is cycled through a full normal process cycle, the particle count in the silicon electrode reactor was found to be 36 particles, i.e. not significantly increased. However, the particle level in the graphite electrode reactor was found to be 299 particles, rather than the 70 particles which were found when rf power was not applied. Thus, it may be seen that the reactor in the process of the present invention provides substantial benefits in particulate reduction.

The present invention has been described with reference to the principal preferred embodiments thereof, but, as will be apparent to thosed skilled in the art, the present invention can be widely modified and varied, and the invention is not limited except as specified in the claims.

## Claims

1. A plasma reactor comprising: a susceptor with means for holding a semiconductor wafer thereon;
   an electrode comprising monocrystalline silicon; and
   means for applying rf power between said susceptor and said electrode.

2. The reactor of claim 1, wherein said electrode is larger than said wafer.

3. The reactor of claim 1, wherein said electrode is thicker than 1,58 mm

4. The reactor of claim 1, wherein said electrode and susceptor are substantially parallel and opposing, and are separated by less than two centimeters.

5. The reactor of claim 1, wherein said susceptor further comprises means for cooling said wafer.

6. The reactor of claim 1, wherein said susceptor is adapted to hold only one said wafer at a time.

7. The reactor of claim 6, further comprising means for opening and closing said reactor, so that wafers can be processed while said susceptor and electrode are at a first separation distance and wafers can be removed and inserted while said susceptor and electrode are at a second separation distance which is more than twice said first separation distance.

8. The reactor of claim 6, wherein said electrode further comprises holes in the face thereof sufficiently large for gas to flow through.

9. The reactor of claim 8, wherein said electrode is connected to a gas supply to flow gas through said holes.

10. The reactor of claim 8, further comprising means for exhausting process gases around the perimeter of said wafer.

11. A process for plasma treatment of integrated circuit wafers, comprising the steps of:
    inserting a wafer onto a susceptor in a vacuum chamber;
    evacuating said vacuum chamber and flowing predetermined process gases therein;
    applying rf power between said susceptor and a monocrystalline silicon electrode.

12. The process of claim 11, wherein said process gases comprise a substantial percentage of a fluorine-bearing species.

13. The process of claim 12, wherein said wafer has a mask layer over an oxide layer at the surface thereof, said mask layer being patterned to expose predetermined pattern areas of said oxide to be etched by species released from said fluorine-bearing species.

## Revendications

1. Réacteur à plasma comprenant :
    un support ayant un dispositif de retenue d'une tranche semi-conductrice sur lui,
    une électrode comprenant du silicium monocristallin, et
    un dispositif destiné à appliquer de l'énergie à haute fréquence entre le support et l'électrode.

2. Réacteur selon la revendication 14, dans lequel l'électrode est plus grande que la tranche.

3. Réacteur selon la revendication 1, dans lequel l'électrode a une épaisseur supérieure à 1,58 mm.

4. Réacteur selon la revendication 1, dans lequel l'électrode et le support sont sensiblement parallèles et placés en regard, et ils sont séparés par une distance inférieure à 2 cm.

5. Réacteur selon la revendication 1, dans lequel le support comprend en outre un dispositif de refroidissement de la tranche.

6. Réacteur selon la revendication 1, dans lequel le support est destiné à supporter une seule tranche à la fois.

7. Réacteur selon la revendication 6, comprenant en outre un dispositif destiné à ouvrir et fermer le réacteur afin que des tranches puissent être traitées lorsque le support et l'électrode sont à une première distance de séparation et que des tranches puissent être retirées et introduites alors que le support et l'électrode sont à une seconde distance de séparation qui est plus de deux fois plus grande que la première distance de séparation.

8. Réacteur selon la revendication 6, dans lequel l'électrode comporte en outre des trous formés dans sa face et suffisamment grands pour qu'un gaz puisse y circuler.

9. Réacteur selon la revendication 8, dans lequel l'électrode est connectée à une source de gaz afin qu'un gaz circule dans les trous.

10. Réacteur selon la revendication 8, comprenant en outre un dispositif destiné à évacuer les gaz de traitement autour de la périphérie de la tranche.

11. Procédé de traitement de tranches de circuits intégrés par un plasma, comprenant les étapes suivantes :
    l'introduction d'une tranche sur un support dans une chambre sous vide,
    l'évacuation de la chambre sous vide et la circulation dans celle-ci de gaz prédéterminés de traitement, et
    l'application d'énergie à haute fréquence entre le support et une électrode de silicium monocristallin.

12. Procédé selon la revendication 11, dans lequel les gaz de traitement contiennent un pourcentage important d'une espèce contenant du fluor.

13. Procédé selon la revendication 12, dans lequel la tranche a une couche formant un masque placée sur une couche d'oxyde, à sa surface, la couche formant un masque constituant un dessin permettant l'exposition de zones prédéterminées du dessin d'oxyde à attaquer par une espèce libérée par l'espèce contenant du fluor.

**Ansprüche**

1. Plasmareaktor mit einem Aufnehmer mit Mitteln zum Halten einer Halbleiterscheibe, einer Elektrode aus monokristallinem Silicium und Mitteln zum Anlegen von HF-Energie zwischen den Aufnehmer und die Elektrode.

2. Reaktor nach Anspruch 1, bei welchem die Elektrode größer als die Scheibe ist.

3. Reaktor nach Anspruch 1, bei welchem die Elektrode dicker als 1,58 mm ist.

4. Reaktor nach Anspruch 1, bei welchem die Elektrode und der Aufnehmer im wesentlichen parallel und gegenüberliegend angeordnet und um weniger als 2 cm voneinander getrennt sind.

5. Reaktor nach Anspruch 1, bei welchem der Aufnehmer außerdem Mittel zum Kühlen der Scheibe enthält.

6. Reaktor nach Anspruch 1, bei welchem der Aufnehmer gleichzeitig jeweils nur eine Scheibe halten kann.

7. Reaktor nach Anspruch 6, mit Mitteln zum Öffnen und Schließen des Reaktors, so daß Scheiben bearbeitet werden können, während der Aufnehmer und die Elektrode in einem ersten Trennabstand voneinander liegen und Scheiben entnommen und eingeführt werden können, während der Aufnehmer und die Elektrode in einem zweiten Trennabstand voneinander liegen, der mehr als zweimal größer als der erste Trennabstand ist.

8. Reaktor nach Anspruch 6, bei welchem die Elektrode ferner in ihrer Fläche Löcher aufweist, die genügend weit für das Hindurchströmen von Gas sind.

9. Reaktor nach Anspruch 8, bei welchem die Elektrode an einen Gasvorrat angeschlossen ist, damit Gas durch die Löcher strömt.

10. Reaktor nach Anspruch 8, ferner mit Mitteln zum Absaugen von Prozeßgasen rund um den Umfang der Scheibe.

11. Verfahren zur Plasmabehandlung integrierter Schaltungsscheiben, gekennzeichnet durch folgende Schritte: Einführen einer Scheibe auf einen Aufnehmer in einer Unterdruckkammer; Evakuieren der Unterdruckkammer und Strömenlassen vorbestimmter Prozeßgase in der Kammer; Anlegen von HF-Energie zwischen den Aufnehmer und eine monokristalline Siliciumelektrode.

12. Verfahren nach Anspruch 11, bei welchem die Prozeßgase einen beträchtlichen Prozentsatz einer Fluor enthaltenden Art umfassen.

13. Verfahren nach Anspruch 12, bei welchem die Scheibe über einer Oxidschicht auf ihrer Oberfläche eine Maskenschicht aufweist, wobei die Maskenschicht mit einem Muster versehen ist, damit vorbestimmte Musterbereiche des Oxids freigelegt werden, die durch von den Fluor haltenden Arten freigesetzten Arten geätzt werden.

Fig.1

EP 0 210 605 B1

Fig. 2

Fig. 3

EP 0 210 605 B1